# EUROPÄISCHE PATENTSCHRIFT

(11) **EP 1 902 479 B1**
(45) Veröffentlichungstag und Bekanntmachung des Hinweises auf die Patenterteilung: **09.06.2010**
(21) Anmeldenummer: 06761719.1
(22) Anmeldetag: 28.06.2006
(51) Int. Cl.: H01L 39/14

(54) **ANORDNUNG AUS TRÄGER UND SUPRALEITENDEM FILM, VORTEXDIODE, UMFASSEND EINE DERARTIGE ANORDNUNG SOWIE VERWENDUNG VON VORTEXDIODEN FÜR FILTER**
ARRANGEMENT COMPRISING A SUPPORT AND SUPER-CONDUCTIVE FILM, VORTEX DIODE COMPRISING SAID TYPE OF ARRANGEMENT AND USE OF VORTEX DIODES FOR FILTERS
SYSTEME COMPORTANT UN SUPPORT ET UN FILM SUPRACONDUCTEUR, DIODE VORTEX COMPRENANT UN SYSTEME DE CE TYPE ET UTILISATION DE DIODES VORTEX POUR DES FILTRES

(30) Priorität: 12.07.2005 DE 102005032422
(43) Veröffentlichungstag der Anmeldung: 26.03.2008
(73) Patentinhaber: Forschungszentrum Jülich GmbH, 52425 Jülich (DE)
(72) Erfinder: WÖRDENWEBER, Roger, 52382 Niederzier (DE)
(86) Internationale Anmeldenummer: PCT/DE2006/001112
(87) Internationale Veröffentlichungsnummer: WO 2007/006252

(56) Entgegenhaltungen:
- DE-A1- 19 927 661
- VILLEGAS J E ET AL: "A superconducting reversible rectifier that controls the motion of magnetic flux quanta" SCIENCE AMERICAN ASSOC. ADV. SCI USA, Bd. 302, Nr. 5648, 14. November 2003 (2003-11-14), Seiten 1188-1191, XP002408726 ISSN: 0036-8075
- WORDENWEBER R ET AL: "Guided vortex motion in high-Tc superconducting thin films and devices with special arrangements of artificial defects" PHYSICA C, NORTH-HOLLAND PUBLISHING, AMSTERDAM, NL, Bd. 404, Nr. 1-4, 1. Mai 2004 (2004-05-01), Seiten 421-425, XP004503420 ISSN: 0921-4534
- VILLEGAS J E ET AL: "Experimental ratchet effect in superconducting films with periodic arrays of asymmetric potentials" PHYSICAL REVIEW B (CONDENSED MATTER AND MATERIALS PHYSICS) APS THROUGH AIP USA, Bd. 71, Nr. 2, 1. Januar 2005 (2005-01-01), Seiten 245191-245195, XP002408727 ISSN: 0163-1829
- VAN LOOK L ET AL: "Anisotropic vortex pinning by a square array of rectangular antidots" PHYSICA C, NORTH-HOLLAND PUBLISHING, AMSTERDAM, NL, Bd. 369, Nr. 1-4, 15. März 2002 (2002-03-15), Seiten 113-117, XP004339833 ISSN: 0921-4534
- HOFFMANN A ET AL: "Periodic vortex pinning with magnetic and nonmagnetic dots: The influence of size" PHYSICAL REVIEW B (CONDENSED MATTER) APS THROUGH AIP USA, Bd. 61, Nr. 10, 1. März 2000 (2000-03-01), Seiten 6958-6965, XP002408772 ISSN: 0163-1829

## Beschreibung

Die Erfindung betrifft eine Anordnung aus Träger und supraleitendem Film, eine Vortexdiode, umfassend eine derartige Anordnung sowie die Verwendung von Vortexdioden für Filter.

Aus J. E. VILLEGAS et al.:"A superconducting reversible rectifier that controls the motion of magnetic flux quanta", SCIENCE, Bd. 302, Nr. 5648, 14. November 2003, Seiten 1188-1191 und R. WORDENWEBER et al.:" Guided vortex motion in high- Tc superconducting thin films and devices with special arrangements of artifical defects", PHYSICA C, Bd. 404, Nr. 1- 4,-1. Mai 2004, Seiten 421-425 ist eine Anordnung aus einem Träger und einem supraleitendem Film bekannt.

Aus dem Stand der Technik sind zudem Resonatoren zum Filtern von Signalen bekannt, wie z. B. Hohlraumresonatoren, dielektrische, λ/2- oder LC-Resonatoren.

Nachteilig sind die bekannten Resonatoren relativ groß. Einer Miniaturisierung dieser Filter sind Grenzen gesetzt, da eine solche regelmäßig zu einer Abnahme der Güte führt.

Das Filtern mehrerer Frequenzbeiträge erfolgt üblicherweise durch Splitten des Signals in unterschiedliche Kanäle. In diesen wird das Signal mit zusätzlicher Elektronik auf die verschiedenen Frequenzen hin untersucht. Alternativ ist ein aufwendiges Verfahren zum Scannen von Frequenzen bekannt. Auch dabei ist nachteilig eine nachgeschaltete Elektronik und gegebenenfalls eine Verstärkung des Ausgangssignals erforderlich.

Aus dem Stand der Technik sind Typ-II-Supraleiter für Filterzwecke bekannt. Diese verdrängen ein Magnetfeld vollständig bis zu einem Wert des magnetischen Flusses von H_{c1} < H_{c}, bleiben aber bis zu einem Wert H_{c2} > H_{c} noch supraleitend, wobei H_{c} die thermodynamisch definierte kritische Magnetfeldstärke ist.

Im Gegensatz zu Typ-I-Supraleitern dringt bei Typ-II-Supraleitern das Magnetfeld für Felder mit Werten zwischen H_{c1} und H_{c2} teilweise in den Supraleiter ein. Wegen der für den magnetischen Fluss geltenden Quantenbedingung und der energetisch vorteilhaften Bildung von normal supraleitenden Grenzflächen, kann das Magnetfeld nur als Flussfäden vorliegen.

Flussfäden sind mikroskopische Objekte mit einem normal leitenden Kern von einigen Nanometern Durchmesser und einem magnetischen Fluss, der im Supraleiter exakt einem Flussquant Φₒ (= 2×10⁻¹⁵ Weber) entspricht. In Hohlräumen im Supraleiter, wie z.B. in Löchern oder supraleitenden Ringen, entspricht der magnetische Fluss ganzzahligen Vielfachen des Flussquants.

Um Typ-II-Supraleiter als Leitermaterial, z. B. für Magnetspulen oder Kabel zu nutzen, müssen sie im Magnetfeld relativ große Ströme verlustfrei tragen können. Dazu werden die Flussfäden örtlich über Haftzentren fixiert. Ohne eine Fixierung würden sie bei Anlegen eines Stroms durch den Supraleiter aufgrund der Lorentz-Kraft F_{L} bewegt werden und dissipative Effekte und damit einen elektrischen Widerstand erzeugen. Typ-II-Supraleiter mit solchen Haftzentren werden auch als harte Supraleiter bezeichnet.

Aus DE 199 27 661 A1 ist eine Anordnung aus Träger und supraleitendem Film mit Löchern bekannt. Die Löcher dienen der Verankerung von Flussfäden. Ein Hochfrequenz(HF-)filter mit derartiger Anordnung zeigt eine verbesserte HF-Festigkeit.

Nachteilig ist bei den Filtern gemäß Stand der Technik immer eine nachgeschaltete Elektronik erforderlich, die das Signal in ein verwertbares DC-Signal konvertiert. Auch ist es mit den Filtern gemäß Stand der Technik bisher nicht möglich, mehrere Frequenzbeiträge aus einem Signal gleichzeitig zu filtern.

Je nach Filter umfasst die Elektronik zum Konvertieren in ein DC-Signal z. B. einen der Anwendung nach angepassten HF-Wandler oder eine HF-Leistungsmessanordnung.

Aufgabe der Erfindung ist es, eine Anordnung aus einem Träger und einem supraleitenden Film für einen Filter mit direkter Wandlung des Signals in ein DC-Signal bereit zu stellen.

Es ist eine weitere Aufgabe der Erfindung, einen Filter bereit zu stellen, mit dem mehrere Frequenzbeiträge ohne eine nachgeschaltete Elektronik gleichzeitig herausgefiltert und in ein DC-Signal konvertiert werden können.

Die Aufgabe wird durch eine Anordnung mit der Gesamtheit der Merkmale nach Anspruch 1 sowie durch eine Vortexdiode und die Verwendung von Vortexdioden für einen Filter gemäß Nebenansprüche gelöst.

Vorteilhafte Ausgestaltungen ergeben sich aus den jeweils darauf rückbezogenen Ansprüchen.

Die erfindungsgemäße Anordnung umfasst einen Träger und einen darauf angeordneten supraleitenden Film, vorzugsweise aus einem Typ-II-Supraleiter.

Im Rahmen der Erfindung wurde erkannt, dass durch eine asymmetrische Formgebung, Größe oder Anordnung der Löcher im Streifenleiter bzw. im supraleitenden Film eine gerichtete Bewegung von magnetischen Flussfäden, im englischen Sprachgebrauch Vortices genannt, von einer Seite des Films zur anderen erzeugt wird. Die Begriffe Flussfäden und Vortices werden im Weiteren synonym verwendet.

Der supraleitende Film weist eine Mehrzahl von Löchern zur Ausbildung eines Lochgitters im Film auf. Reihen runder Löcher mit fortschreitender Größe oder dreieckige, nicht-gleichseitige Löcher, welche in dem supraleitenden Film in einer ausgewählten Orientierung angeordnet sind, kennzeichnen die Anordnung. Beide Geometrien im supraleitenden Film haben sich als vorteilhaft zur Lösung der Aufgabe herausgestellt.

Mit den Bezeichnungen "rund" und "dreieckig" sind auch annähernd runde bzw. dreieckige Strukturen umfasst. Darüber hinaus kann die Bezeichnung "rund" alle runden Strukturen umfassen, das heißt neben den bevorzugten kreisrunden auch ovale oder z. B. auch ellipsoide Strukturen.

Es ist auch möglich, eine Anordnung aus Träger und supraleitendem Film vorzusehen, bei dem die Löcher eine identische Geometrie aufweisen und mäanderförmig im supraleitenden Film angeordnet sind. Eine Mäanderform liegt bei Lochreihen mit wenigstens zwei Umkehrpunkten vor, bei denen die Löcher von einem Ende zum anderen des supraleitenden Films angeordnet sind.

Ebenfalls vorstellbar ist es, eine geeignete Kombination der oben genannten Merkmale im supraleitenden Film der Anordnung vorzusehen.

Nur beispielhaft seien Dreiecke in Mäanderform im supraleitenden Film oder auch in Kombination mit runden Löchern genannt. Es können aber auch andere geeignete Kombinationen dieser Merkmale den gewünschten Effekt der Signalkonversion erzeugen.

In einer Ausgestaltung der Erfindung weist das Lochgitter im supraleitenden Film Löcher mit einer Größe zwischen vorzugsweise 50 und 50000 Nanometer auf. Vorzugsweise sollte der Lochabstand von Lochmittelpunkt zu Lochmittelpunkt in einem Bereich von etwa 100 bis 50000 Nanometer liegen.

Besonders vorteilhaft sind Hochtemperatursupraleiter aus z. B. ReBa₂Cu₃O₇, mit Re = Seltenerdmetall.

Als Materialien sind weiterhin BaSrCaCuO-Verbindungen, Tl-HTSL, Nb, Pb, Nb-Verbindungen sowie A15-Supraleiter denkbar.

Diese Materialien lassen sich vorteilhaft als dünne Schicht auf hochfrequenztauglichen Trägern abscheiden und sind so genannte Typ-II-Supraleiter mit einer großen Eindringtiefe und somit kleinen kritischen Feldern B_{c1}.

Der supraleitende Film kann als dünne Schicht insbesondere mit einer Dicke von 0,1 bis 2,0 µm auf dem Träger angeordnet sein.

Als Trägermaterial sind insbesondere hochfrequenztaugliche Materialien vorgesehen, z. B. Einkristalle aus Saphir, LaAlO₃, MgO oder Silizium.

Diese Materialien weisen vorteilhaft niedrige HF-Verluste und gute Trägereigenschaften auf. Sie sind daher für Filter besonders geeignet.

Die erfindungsgemäße Anordnung aus supraleitendem Film und Träger ist so ausgestaltet, dass sie eine Vortexdiode auszubilden vermag.

Die Asymmetrie durch die Formgebung wird durch in Reihen angeordnete, nicht-gleichseitige Dreiecke oder durch die Größe, z. B. durch fortschreitende Größe der Löcher oder durch die Anordnung der Löcher in Form einer mäandrierenden Anordnung ausgebildet.

Auf diese Weise wird durch die Anordnung und/oder Form der Löcher im supraleitenden Film die Bewegung der Flussfäden vorbestimmbar gerichtet und das DC-Signal erzeugt.

Die Bewegung der Flussfäden wird bei ausreichender Signalamplitude und ausreichend niedriger Frequenz des Signals in eine Richtung bis zum Ende des supraleitenden Films, bzw. Streifenleiters vorgegeben. Dabei werden die Flussfäden von einem Loch zum nächsten mit einer durch die Asymmetrie im Lochgitter des supraleitenden Films vorgegebenen Richtung bewegt.

In der Vortexdiode erzeugt ein Wechselstromsignal durch die bevorzugte Richtung der Bewegung der Flussfäden das Gleichspannungssignal.

Die gerichtete Bewegung der Flussfäden kann durch ein regelmäßiges Gitter von nicht-gleichseitigen, aber gleichschenkligen, dreieckigen Löchern hervorgerufen werden. Löcher aus spitzwinkligen Dreiecken mit Ausrichtung der Spitzen senkrecht zur Stromrichtung verursachen eine präferentielle Vortexbewegung in Richtung des spitzen Winkels. Die physikalische Ursache der präferentiellen Vortexbewegung liegt hierbei in der lokal unterschiedlichen Dichte des Abschirmstromes, der um jedes Loch im Supraleiter fließt, und den magnetischen Fluss im Loch zum Supraleiter hin abschirmt. Die Stromdichte ist an der Spitze des Dreiecks überhöht, daher ist eine Nukleation von Flussfäden an dieser Stelle auf Grund der lokal reduzierten supraleitenden Eigenschaften wahrscheinlicher, als an den anderen Stellen des Lochrandes. Durch die erleichterte Nukleation von Flussfäden wird daher auch deren Bewegung aus der Spitze des Dreieckes heraus einfacher.

Ein gerichteter Transport der Flussfäden durch Größenvariation der Löcher wird auch durch die Verwendung von kreisrunden Löchern mit fortschreitender Größe innerhalb einer Reihe erreicht. Hierbei wird die Abhängigkeit der Flussfäden-Loch-Wechselwirkung von der Lochgröße ausgenutzt. Größere Löcher ziehen die Flussfäden stärker an als kleine Löcher. Daher erfolgt der Transport der Flussfäden ausgehend von den kleinsten Löchern in Richtung der Löcher mit zunehmend größerem Radius, das heißt es wird eine Vortexbewegung zu den größeren Löchern hin bevorzugt.

Schließlich kann auch die Richtung der Lorentzkraft senkrecht zu Strom und magnetischem Feld auf die Flussfäden ausgenutzt werden. Hierzu ist es nötig, die Anordnung der Löcher geeignet zu wählen. Es kann eine wellenförmige, mäandrierende Anordnung von Reihen von gleichartigen Löchern verwendet werden, die einerseits beide Seiten des Streifenleiters verbinden und bei denen andererseits an den Umkehrpunkten die Flussfäden nahezu parallel zum Strom (sog. force-free-Konfiguration, da Lorentzkraft senkrecht zum Strom) einlaufen, um dann nach Invertierung des Stromes senkrecht zum Strom (maximale Lorentzkraft) in den nächsten Bogen auszulaufen. Es ist möglich, in der Mäanderform, z. B. an den Umkehrpunkten Löcher mit vergrößertem Durchmesser vorzusehen.

Alle genannten Möglichkeiten ermöglichen den Aufbau einer Vortexdiode und beruhen jeweils auf unterschiedlichen physikalischen Gesetzmäßigkeiten der Vortexphysik in Supraleitern. Sie können gegebenenfalls auch miteinander kombiniert werden, z.B. durch Reihen von größer werdenden Dreiecken. Ein Fachmann auf dem Gebiet der Supraleitung ist bei der Erzeugung neuartiger Vortexdioden für Filter jedenfalls nicht durch die hier genannten Ausführungsbeispiele beschränkt.

Abhängig von der Bewegung der Flussfäden wird in der Vortexdiode ein elektrisches Feld senkrecht zur Bewegung der Flussfäden induziert. Die auf diese Weise erzeugte DC-Spannung wird über Kontakte abgegriffen und in Beziehung gesetzt zur gefilterten Frequenz.

Das eingekoppelte AC- bzw. HF-Signal induziert im supraleitenden Film einen AC-Strom. Ein magnetischer Fluss wird bereits auf Grund des vorhandenen Erdfeldes im Supraleiter induziert. Bei geeigneten Typ-II-Supraleitern und geeigneter Geometrie der Vortexdiode reichen schon kleinste Felder aus, um hohe Dichten von Flussfäden im supraleitenden Film zu erzeugen. So werden z. B. im Erdfeld von etwa 0,5 Gauss etwa 25000 Flussfäden je mm² im supraleitenden Film gebildet.

Es ist aber z. B. auch möglich, eine elektromagnetische Spule zur Generierung höherer Flussfädendichten im supraleitenden Film vorzusehen.

Die Flussfäden wechselwirken mit dem AC-Strom und bewegen sich auf Grund der vom Strom erzeugten Lorentzkraft F_{L} von einem Loch zum nächsten. Die Flussfäden versuchen der Lorentzkraft F_{L} zu folgen. Durch die attraktive Vortex-Loch-Wechselwirkung erfolgt bei ausreichender Signalamplitude und ausreichend niedriger Signalfrequenz eine gerichtete Bewegung der Flussfäden von Loch zu Loch. Die Bewegung der Flussfäden induziert den magnetischen Flusstransport und somit ein elektrisches Feld senkrecht zur Bewegung der Flussfäden bzw. antiparallel zum Strom. Die diesem entsprechende Spannung liegt an den Kontakten des Filters vor und wird abgegriffen und ausgewertet.

Die Bewegung der Flussfäden findet als Diodeneffekt somit vornehmlich in eine Richtung statt, woraus eine DC-Spannung resultiert.

Vorteilhaft ist mit der erfindungsgemäßen Anordnung aus Träger und supraleitendem Film, bzw. Streifenleiter in der Vortexdiode eine nachgeschaltete Elektronik zur Wandlung des Signals in ein DC-Signal verzichtbar.

Durch die Periodizität des Lochgitters in Verbindung mit den Materialeigenschaften ist das erzeugte Signal maximal, wenn die Bewegung der Flussfäden innerhalb der Löcher einer Reihe synchron von Loch zu Loch erfolgt.

Dies führt unmittelbar zur gewünschten Frequenzabhängigkeit des erzeugten Signals.

In Abhängigkeit von der eingekoppelten Frequenz des Signals erhält man eine Netto-Bewegung von Flussfäden bzw. einen magnetischen Fluss in eine vorgegebene Richtung.

Die Anordnung weist zur Ausbildung einer Vortexdiode regelmäßig weitere Kontakte am supraleitenden Film auf. Über einen Eingangskontakt wird das Signal eingespeist und in den supraleitenden Streifenleiter geleitet. Über einen Ausgang werden diese wieder abgeleitet, z. B. auf eine Erdung oder einen 50Ω-Abschluss.

An Spannungskontakten wird das DC-Signal jeweils differenziell abgegriffen.

Die Vortexdiode weist Mittel zum Kühlen des Supraleiters unterhalb seiner kritischen Temperatur auf.

Die Bewegung (engl. guided motion) der Flussfäden in einer Vortexdiode ist maximal, wenn die Reihen parallel zur Lorentzkraft und somit senkrecht zu einem Stromfluss in der Anordnung ausgerichtet ist. Sie ist minimal im Falle der Ausrichtung der Reihen senkrecht zur Lorentzkraft.

Ein Filter mit der erfindungsgemäßen Anordnung bzw. Vortexdiode weist ebenfalls die verbesserten Eigenschaften der Anordnung auf. Dabei werden vorteilhaft Frequenzen bis etwa 100 GHz gefiltert und direkt in ein DC-Signal konvertiert.

Ein Filter mit erfindungsgemäßer Anordnung weist in Bezug auf die Signalkonversion die verbesserte Eigenschaft auf, da ohne eine zusätzliche Wandelelektronik das DC-Signal erzeugt und abgegriffen werden kann. Besonders vorteilhaft ist ein erfindungsgemäßer Filter im Gegensatz zu bekannten Filtern vergleichsweise klein ohne in der Güte beeinträchtigt zu sein.

Zur Ausbildung des Filters weist dieser mindestens eine erfindungsgemäße Anordnung aus supraleitendem Film und Träger bzw. eine Vortexdiode aus.

In den Filter wird mittels einer Antenne das Signal eingekoppelt. Hiernach wird das Signal in dem asymmetrisch strukturierten, supraleitenden Film in eine gerichtete Bewegung von Flussfäden überführt.

In einem erfindungsgemäßen Filter sind vorzugsweise Vortexdioden mit etwa 10 bis zu 10000 Lochreihen zur Ausbildung des Lochgitters vorgesehen. Mit zunehmender Anzahl von Reihen nimmt die Güte des Filters zu.

Der Lochabstand im supraleitenden Film einer erfindungsgemäßen Anordnung bzw. Vortexdiode in Bewegungsrichtung der Flussfäden ist konstant.

Auch ein erfindungsgemäßer Filter weist regelmäßig Mittel zum Kühlen, wie z. B. einen Kryokühler oder Flüssigkühlmittel auf.

Darüber hinaus weist er Mittel zur Ein- und Auskopplung des Signals und eine der Anzahl der Frequenzbeiträge entsprechende Anzahl von Paaren von Abgriffen der DC-Signale auf.

Ein Filter kann somit vorteilhaft auch mehr als nur eine Vortexdiode umfassen.

Sofern mehrere Vortexdioden mit zueinander verschiedenartigen Lochgittern in dem Filter angeordnet sind, können besonders vorteilhaft mehrere Frequenzbeiträge gleichzeitig gefiltert und konvertiert werden. Der supraleitende Film mit Lochgitter in den Vortexdioden weist die Funktion des Streifenleiters auf, indem das eingekoppelte Signal ohne Verlust weitergeleitet wird. Durch die Streifenleiter mit unterschiedlichem Lochgitter können gleichzeitig unterschiedliche Frequenzen gefiltert und konvertiert werden.

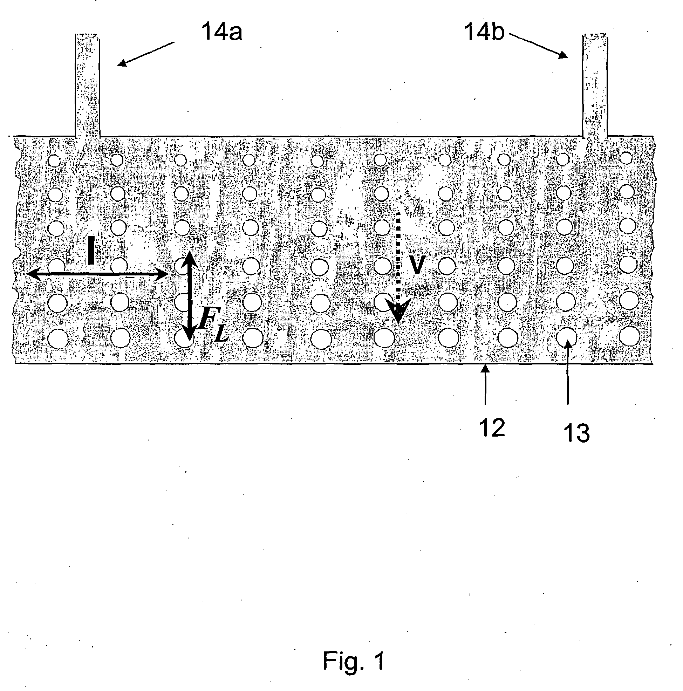

Im Weiteren wird die Erfindung an Hand von Ausführungsbeispielen und den beigefügten Figuren 1 bis 5 näher beschrieben.

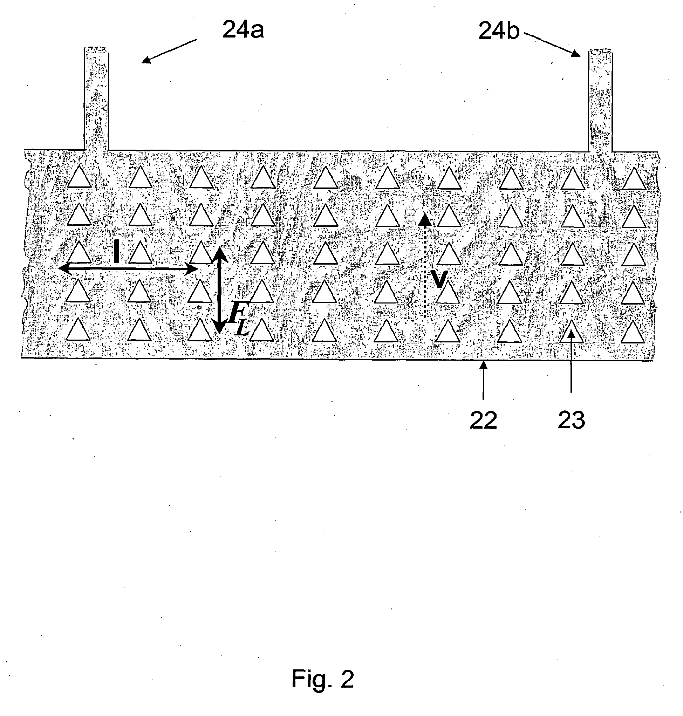

Fig. 1 und 2 zeigen in Aufsicht je grob schematisch ein erfindungsgemäßes Lochgitter in einem supraleitenden Film 12, 22. Das Lochgitter umfasst je insgesamt n (hier: n=10) senkrecht angeordnete Reihen kreisrunder bzw. dreieckiger, nicht-gleichseitiger Löcher. Für die DC-Signalentwicklung sind jeweils die Reihen zwischen den Kontakten 14a, 14b bzw. 24a, 24b maßgeblich.

Mit I ist jeweils der AC-Strom und mit F_{L} die LorentzKraft bezeichnet. Die Doppelpfeile geben die Richtung des AC-Stroms bzw. der Lorentzkraft auf Grund eines angelegten HF-Signals an. Mit v ist die Bewegung der Flussfäden angegeben. Der gepunktete Pfeil gibt demnach die Richtung der präferentiellen Bewegung der Flussfäden im supraleitenden Film an.

In Fig. 1 ist der Abstand der Löcher 13 in Bewegungsrichtung der Flussfäden von Lochrand zu Lochrand innerhalb der senkrechten Reihen konstant und kann zwischen 0,5 bis 20 µm betragen. Der Abstand der senkrechten Reihen zueinander kann zwischen 1 bis 500 µm variieren. Die Lochgröße kann zwischen etwa 0,5 bis 50 µm Durchmesser betragen.

In Fig. 2 ist der Abstand der dreieckigen, nicht-gleichseitigen Löcher 23 von Lochrand zu Lochrand innerhalb der senkrechten Reihen konstant und kann etwa zwischen 0,5 bis 20 µm betragen. Der Abstand der Reihen zueinander kann zwischen 1 bis 500 µm variieren.

Die Lochgröße beträgt etwa 0,5 bis 20 µm.

In Fig. 1 wird eine Asymmetrie durch kleiner werdende Löcher 13 in den Reihen, in Fig. 2 hingegen durch die Form der dreieckigen, nicht-gleichseitigen Löcher 23 als solche erzeugt und damit die Bewegung der Flussfäden in der Diode vorgegeben. In beiden supraleitenden Filmen 12, 22 wird daher eingekoppeltes AC- bzw. HF-Signal in ein DC-Signal überführt und über die Kontakte 14a und 14b (Fig. 1) bzw. 24a und 24b (Fig. 2) abgegriffen und über ein Voltmeter (nicht dargestellt) differentiell gemessen.

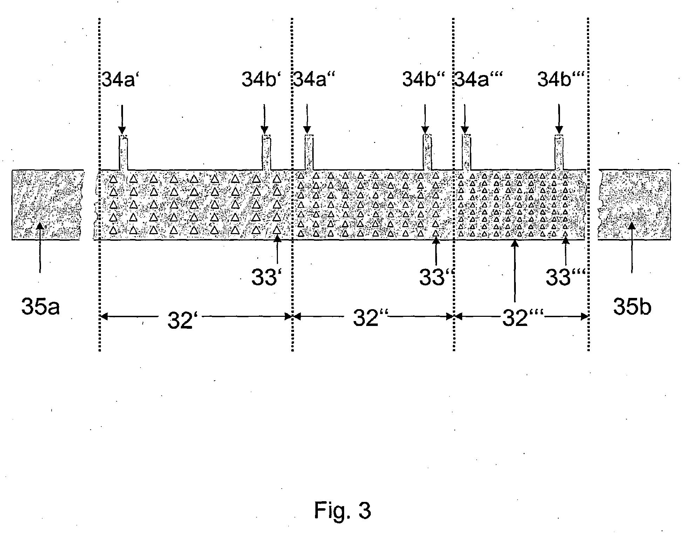

Fig. 3 zeigt eine Reihenschaltung unterschiedlicher Lochgitter zum simultanen Filtern unterschiedlicher Frequenzbeiträge eines HF-Signals von Eingang 35a zu Ausgang 35b. Gepunktete Linien grenzen die Teilabschnitte im supraleitenden Film zur Ausbildung der Vortexdioden 32', 32", 32'" voneinander ab. Im Abschnitt 32' sind sieben Reihen, im Abschnitt 32" und 32'" jeweils acht senkrechte Reihen an dreieckigen, nicht-gleichseitigen Löchern zwischen den DC-Abgriffen angeordnet.

Der Abstand der Löcher von Lochrand zu Lochrand innerhalb der senkrechten Reihen im Abschnitt 32', 32" und 32'" kann zwischen 0,5 bis 20 µm variieren. Der Abstand der Reihen zueinander beträgt etwa 1 bis 500 µm.

Die Abschnitte 32', 32" und 32'" bilden jeweils eine Vortexdiode aus, so dass im vorliegenden Fall insgesamt drei Vortexdioden zum Filtern dreier Frequenzbeiträge vorgesehen sind.

Entscheidend zur Ausbildung der Vortexdioden ist, dass der Abstand der dreieckigen, nicht-gleichseitigen Löcher 33', 33" und 33'" in den senkrecht angeordneten Reihen von Abschnitt 32' über 32" nach 32'" jeweils abnimmt und somit mehr Löcher je Reihe angeordnet sind. In Abschnitt 32' sind 5 Löcher je Reihe, in Abschnitt 32" sind 7 Löcher je Reihe und in Abschnitt 32'" sind 9 Löcher je Reihe schematisch dargestellt. Ein Filter wird realisiert durch ein Vielfaches an Lochreihen und Löchern.

Im Hochfrequenzfilter gemäß Fig. 3 werden Frequenzbeiträge in den supraleitenden Streifenleiter in Eingang 35a eingespeist und fließen durch die unterschiedlichen Dioden zum Ausgang 35b, z. B. einer Erdung. In den unterschiedlichen Abschnitten 32', 32", 32'" wird der jeweilige Frequenzbeitrag herausgefiltert und über die DC-Kontakte 34a' und 34b' bzw. 34a" und 34b" bzw. 34a'" und 34b'" abgegriffen und gemessen (nicht dargestellt).

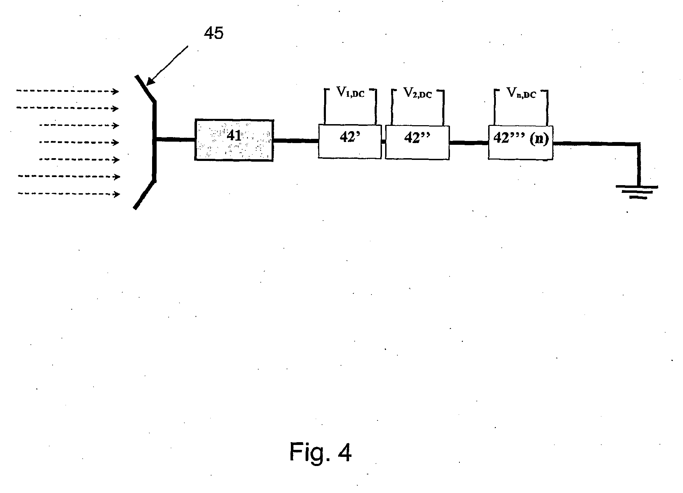

Fig. 4 zeigt schematisch ein Filter auf der Basis von Vortexdioden mit supraleitenden Filmen 42', 42", 42'". Das Signal, dargestellt durch die waagerechten Pfeile wird mittels einer Antenne 4.5 empfangen und optional durch einen Verstärker 41 verstärkt. Das Signal wird nun auf Vortexdioden mit supraleitenden Filmen 42', 42" und 42'" gegeben.

Es ist möglich, eine Vielzahl hintereinander geschalteter Vortexdioden zur Filterung von Frequenzbeiträgen vorzusehen.

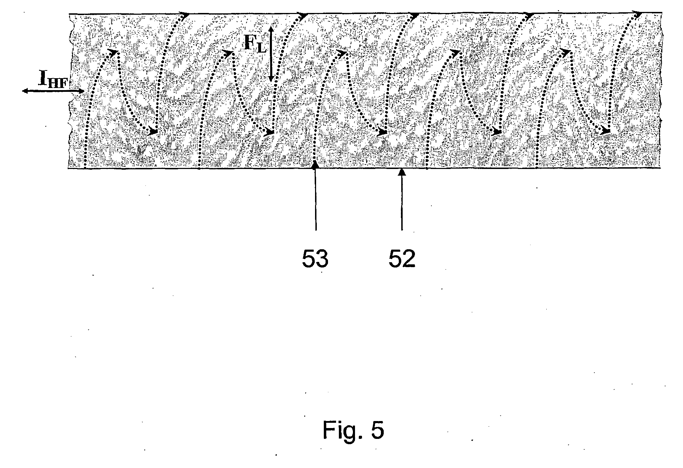

Fig. 5 zeigt eine weitere Möglichkeit zur Ausbildung einer Vortexdiode. Hierbei ist im Gegensatz zu Fig. 1 und 2 nicht die asymmetrische Formgebung von Löchern bzw. Antidots als solche, sondern eine asymmetrische Anordnung gleich ausgestalteter Löcher 53 entscheidend für die bevorzugte Richtung, in der sich die Flussfäden im Streifenleiter bzw. Film 52 bewegen. Die Flussfäden folgen der Lorenzkraft F_{L}, sind aber durch die mäandrierende Anordnung der Löcher 53 gezwungen, sich präferentiell entlang der gepunkteten Lochreihen zu bewegen. An den Umkehrpunkten, dargestellt durch Pfeilspitzen, werden sie jeweils in dem parallel zur Lorentzkraft ausgerichteten Ast weitergeführt. Die Flussfäden bewegen sich dabei mäanderförmig in Pfeilrichtung. Weitere Bauteile, wie Eingang, Ausgang oder Kontakte sind nicht dargestellt.

Das Prinzip der Bewegung der Flussfäden ist in allen Ausführungsbeispielen identisch. In allen Figuren besteht der nicht dargestellte Träger aus einem HFtauglichen Material, z. B. aus Einkristallen umfassend Saphir, LaAlO₃, MgO oder Silizium, deren Dicke entsprechen der Impedanzanpassung (üblicherweise 50 Q) zu wählen ist.

Der supraleitende Film bzw. Streifenleiter 12, 22, 32', 32", 32'", 42', 42", 42'", 52 besteht aus einem Typ-II-Supraleiter, z. B. aus ReBa₂Cu₃O₇, mit Re = Seltenerdmetall, BaSrCaCuO-Verbindung, Tl-HTSL, Nb, Pb oder Nb-Verbindungen oder A15-Supraleiter und ist üblicherweise 0,1 bis 2,0 µm dick. Die gemittelte Wegstrecke rᵥ, die ein Vortex innerhalb einer Halbwelle (positiver bzw. negativer Stromzyklus) des HF-Stroms zurücklegt, ist proportional zur Amplitude des Signals (Iₘₐₓ) und der Zeit τ, während der der Strom vorliegt, das heißt der Zeit der Halbphase. Die Zeit τ ist umgekehrt proportional zur Frequenz f, d.h. τ=1/f. Somit ist die Wegstrecke umgekehrt proportional zur Frequenz, rᵥ ∝ I/f. Um ein messbares Signal zu erzeugen, muss das Vortex während einer Halbwelle eine Strecke größer oder gleich dem halben Antidotabstand überwinden. Da letzterer vorgegeben ist, andererseits die zurückgelegte Strecke umgekehrt proportional zur Frequenz ist, existiert bei gegebener Signalamplitude eine maximale Frequenz, bis zu der Vortices von einem Antidot zum anderen gelangen können. Das Einbringen der Frequenz führt zu einem HF-Signal, und somit zu einem HF-Strom im Leiter. Dieser übt seinerseits über die Wechselwirkung mit dem magnetischen Feld im Flussfaden eine Lorentzkraft auf die Flussfäden aus. Bereits kleinste Felder führen aufgrund der kleinen unteren kritischen Felder B_{c1} und dem Demagnetisierungseffekt in planaren Supraleitern zu beachtlichen Dichten von Flussfäden, wobei Erdfelder üblicherweise ausreichen. Die Bewegung der Flussfäden wird unter anderem durch Wechselwirkung zwischen dem angelegten Strom und dem magnetischen Feld des Vortex induziert. Dabei wechselwirken die Flussfäden mit dem Strom.

Ein DC-Signal entsteht nur, wenn ein Signal ausreichender Amplitude und ausreichend kleiner Frequenz eingekoppelt wird.

Mit den erfindungsgemäßen Filtern lassen sich z. B. Frequenzen von etwa 1 MHz bis 100 GHz filtern und unmittelbar in ein DC-Signal konvertieren.

Es ist möglich, die in den Fig. 1 bis 5 dargestellten supraleitenden Filme und deren Merkmale miteinander in geeigneter Weise zu kombinieren.

## Patentansprüche

1. Anordnung aus einem Träger und einem darauf angeordneten supraleitenden Film, wobei der Film eine Mehrzahl von Löchern zur Ausbildung eines Lochgitters aufweist,
**dadurch gekennzeichnet, dass**
in dem Film runde Löcher mit fortschreitender Größe oder dreieckige, nicht-gleichseitige Löcher oder mäanderförmig angeordnete runde Löcher identischer Größe oder eine Kombination hiervon angeordnet sind.

2. Anordnung nach vorhergehendem Anspruch,
**gekennzeichnet durch**
einen Typ II-Supraleiter als Material für den supraleitenden Film.

3. Anordnung nach einem der vorhergehenden Ansprüche,
**gekennzeichnet durch**
eine Lochgröße zwischen 50 und 50000 Nanometer.

4. Anordnung nach einem der vorhergehenden Ansprüche,
**gekennzeichnet durch** einen supraleitenden Film, umfassend ReBa₂Cu₃O₇, mit Re = Seltenerdenmetall, BaSrCaCaO-Verbindungen, Tl-Verbindungen, Nb, Pb und Nb-Verbindungen oder A15-Supraleiter.

5. Anordnung nach einem der vorhergehenden Ansprüche,
**gekennzeichnet durch**
eine Dicke von 0,1 bis 2,0 µm für den supraleitenden Film.

6. Anordnung nach einem der vorhergehenden Ansprüche,
umfassend Saphir-, LaAlO₃-, MgO- und Si-Einkristalle als Trägermaterial.

7. Vortexdiode, umfassend eine Anordnung aus einem Träger und einem darauf angeordneten supraleitenden Film nach einem der vorhergehenden Ansprüche, wobei der Film als streifenleiter ausgebildet ist.

8. Vortexdiode nach Anspruch 7,
bei der eine Nukleation von Flussfäden an der Spitze der Dreiecke auf Grund einer lokal reduzierten supraleitenden Eigenschaft wahrscheinlicher ist, als an den anderen Stellen des Dreieckes, wodurch die Bewegung der Flussfäden aus der Spitze des Dreieckes heraus erfolgt.

9. Vortexdiode nach Anspruch 7 oder 8,
bei der der Transport der Flussfäden ausgehend von den kleinsten Löchern in Richtung der Löcher mit zunehmend größerem Radius erfolgt.

10. Vortexdiode nach Anspruch 7 bis 9,
bei der an den Umkehrpunkten die Flussfäden nahezu parallel zum Strom über eine sogenannte force-free-Konfiguration einlaufen, um dann senkrecht zum Strom in den nächsten Bogen auszulaufen.

11. Vortexdiode nach einem der Ansprüche 7 bis 10,
umfassend DC-Kontakte zum Abgreifen eines DC-Signals.

12. Vortexdiode nach einem der Ansprüche 7 bis 11,
umfassend Kühlmittel zur Erzeugung von Temperaturen unterhalb der kritischen Temperatur des supraleitenden Films.

13. Vortexdiode nach einem der vorhergehenden Ansprüche 7 bis 12,
**gekennzeichnet durch**
Mittel zum Ausbilden eines magnetischen Feldes stärker als das des Erdmagnetfeldes.

14. Vortexdiode nach Anspruch 13,
**gekennzeichnet durch**
mindestens eine elektromagnetische Spule als Mittel zur Ausbildung des Magnetfeldes.

15. Verwendung von Vortexdioden, insbesondere von Vortexdioden nach einem der vorhergehenden Ansprüche 7 bis 14 für Filter.

16. Verwendung nach vorhergehendem Anspruch 15,
mit mehreren verschiedenartig ausgestalteten Vortexdioden zur Filterung verschiedener Frequenzbeiträge.

## Claims

1. Arrangement comprising a support and a superconductive film thereon, in which the film has a plurality of holes forming a perforated grid, **characterised in that** circular holes of increasing size or triangular, non-equilateral holes or circular holes of identical size arranged in meandering form or a combination of these are arranged in the film.

2. Arrangement according to the preceding claim, **characterised by** a type II superconductor as the material for the superconductive film.

3. Arrangement according to either of the preceding claims, **characterised by** a hole size of between 50 and 50000 nanometres.

4. Arrangement according to any of the preceding claims, **characterised by** a superconductive film containing ReBa₂Cu₃O₇, with Re = rare earth metal, BaSrCaCuO compounds, Tl compounds, Nb, Pb and Nb compounds or A15 superconductor.

5. Arrangement according to any of the preceding claims, **characterised by** a thickness of 0.1 to 2.0 µm for the superconductive film.

6. Arrangement according to any of the preceding claims, containing sapphire, LaAlO₃, MgO and Si monocrystals as the support material.

7. Vortex diode consisting of an arrangement comprising a support and a superconductive film thereon according to any of the preceding claims, in which the film is in the form of a stripline.

8. Vortex diode according to claim 7, in which a nucleation of flux threads is more likely at the apex of the triangle than at the other points of the triangle because of a locally reduced superconductive property, due to which the motion of the flux threads takes place from the apex of the triangle.

9. Vortex diode according to claim 7 or 8, in which the flux threads are conveyed from the smallest holes in the direction of the holes with a progressively larger radius.

10. Vortex diode according to claims 7 to 9, in which the flux threads enter almost parallel to the current at the turning points through a so-called force-free configuration and then exit into the next sheet perpendicular to the current.

11. Vortex diode according to any of claims 7 to 10 containing DC contacts to pick up a DC signal.

12. Vortex diode according to any of claims 7 to 11 containing coolant to generate temperatures below the critical temperature of the superconductive film.

13. Vortex diode according to any of claims 7 to 12, **characterised by** means to form a magnetic field stronger than the earth's magnetic field.

14. Vortex diode according to claim 13, **characterised by** at least an electromagnetic coil as a means of forming the magnetic field.

15. Use of vortex diodes, in particular vortex diodes according to any of the preceding claims 7 to 14, for filters.

16. Use according to the preceding claim 15, with a plurality of differently formed vortex diodes for filtering of different frequency contributors.

## Revendications

1. Système constitué d'un support et, disposé sur ce dernier, d'un film supraconducteur qui présente une pluralité de trous formant un réseau de trous, **caractérisé en ce que**
le film comporte des trous ronds de taille croissante ou des trous triangulaires non équilatéraux ou des trous ronds de taille identique disposés en forme de méandres ou une combinaison de ces types de trous.

2. Système selon la revendication précédente,
**caractérisé par**
un supraconducteur de type II comme matériau pour le film supraconducteur.

3. Système selon l'une des revendications précédentes,
**caractérisé par**
une taille de trou dans la plage de 50 à 50000 nanomètres.

4. Système selon l'une des revendications précédentes,
**caractérisé par** un film supraconducteur comprenant du ReBa₂CU₃O₇, où Re = terre rare, des composés de BaSrCaCuO, des composés de Tl, du Nb, du Pb et des composés de Nb ou des supraconducteurs A15.

5. Système selon l'une des revendications précédentes,
**caractérisé par**
une épaisseur du film supraconducteur dans la plage de 0,1 à 2,0 µm.

6. Système selon l'une des revendications précédentes,
comprenant des monocristaux de saphir, de LaAlO₃, de MgO et de Si comme matériau du support.

7. Diode vortex, comprenant un système constitué d'un support et, disposé sur ce dernier, d'un film supraconducteur selon l'une des revendications précédentes, le film étant réalisé sous la forme d'une microbande

8. Diode vortex selon la revendication 7, dans laquelle une nucléation de lignes de vortex est plus probable à la pointe des triangles, à cause d'une propriété supraconductrice localement réduite, qu'aux autres endroits du triangle, de sorte que le mouvement des lignes de vortex se produit à partir de la pointe du triangle.

9. Diode vortex selon la revendication 7 ou la revendication 8,
dans laquelle le transport des lignes de vortex se fait à partir des trous les plus petits en direction des trous de rayon de plus en plus grand.

10. Diode vortex selon l'une des revendications 7 à 9,
dans laquelle, aux points de rebroussement, les lignes de vortex arrivent pratiquement parallèles au courant, sous l'effet d'une configuration dite à champ sans force, pour sortir ensuite perpendiculaires au courant dans l'arc suivant.

11. Diode vortex selon l'une des revendications 7 à 10,
comprenant des contacts à courant continu pour recevoir un signal continu.

12. Diode vortex selon l'une des revendications 7 à 11,
comprenant des moyens de refroidissement qui permettent de générer des températures inférieures à la température critique du film supraconducteur.

13. Diode vortex selon l'une des revendications 7 à 12 précédentes,
**caractérisée par**
des moyens servant à générer un champ magnétique d'intensité supérieure à celle du champ magnétique terrestre.

14. Diode vortex selon la revendication 13,
**caractérisée par**
au moins une bobine électromagnétique comme moyen de génération du champ magnétique.

15. Utilisation de diodes vortex, en particulier de diodes vortex selon l'une des revendications 7 à 14 précédentes, pour des filtres.

16. Utilisation selon la revendication 15 précédente,
avec plusieurs diodes vortex différemment configurées afin de filtrer différentes contributions fréquentielles.
